(19) Europäisches Patentamt
European Patent Office
Office européen des brevets

(11) **EP 0 403 461 B2**

(12) NEW EUROPEAN PATENT SPECIFICATION

(45) Date of publication and mention
of the opposition decision:
**01.09.1999 Bulletin 1999/35**

(51) Int Cl.[6]: **C23C 30/00**, C23C 16/40

(45) Mention of the grant of the patent:
**01.03.1995 Bulletin 1995/09**

(21) Application number: **90850236.2**

(22) Date of filing: **14.06.1990**

(54) **Coated cutting insert**

Beschichteter Schneideinsatz

Plaquette rapportée revêtue des outils pour l'usinage

(84) Designated Contracting States:
**AT CH DE FR GB IT LI NL SE**

(30) Priority: **16.06.1989 SE 8902179**

(43) Date of publication of application:
**19.12.1990 Bulletin 1990/51**

(73) Proprietor: **SANDVIK AKTIEBOLAG**
**811 81 Sandviken (SE)**

(72) Inventors:
• **Chatfield, Christopher**
**S-147 52 Tumba (SE)**
• **Lindström, Jan**
**S-126 38 Hägersten (SE)**
• **Sjöstrand, Mats**
**S-164 33 Kista (SE)**
• **Collin, Marianne**
**S-122 36 Enskede (SE)**

(74) Representative: **Östlund, Alf Olof Anders et al**
**Sandvik AB**
**Patent Department**
**811 81 Sandviken (SE)**

(56) References cited:
EP-A- 0 032 887    EP-A- 0 045 291
EP-A- 0 083 842    JP-A- 5 464 513
JP-A- 5 479 180    JP-A- 63 157 873
SE-B- 357 984    US-A- 3 736 107
US-A- 3 837 896    US-A- 4 018 631
US-A- 4 180 400

• PATENT ABSTRACTS OF JAPAN, vol. 13, no. 290 (C-614)[3638], July 5, 1989; & JP-A-183662
• R.C. Weast (editor): "Handbook of Chemistry and Physics", 55th edition (1974), p. B-149
• "AGA Gas Handbook", 1985, AGA AB, Lidinggo, Sweden, Ed. Kersti Ahlberg; pp. 544, 559
• Handbook of Metallic Surface Technique, JP; p. 1292
• Proceedings of the 7th European Conference on CVD, 17.-20.06.1985, Uppsala, Sweden, pp. 381-394; Altena H. et al
• Proceedings of the 12th International Plansee Seminar, 08.-12.05.1989, Reutte, AT, pp. 129-142; Skogsmo J. et al

Remarks:
The file contains technical information submitted after the application was filed and not included in this specification

**Description**

The present invention relates to a coated cutting insert for chipforming machining.

Chemical Vapor Deposition of alumina on cutting tools has been an industrial praxis for more than 15 years. The wear properties of $Al_2O_3$ as well as of TiC and TiN have been discussed extensively in the literature.

The CVD technique has also been used to produce coatings of other metal oxides, carbides and nitrides with the metal either selected from the transition metals of the groups IVB, VB and VIB of the Periodic Table or from silicon, boron and aluminium. Many of these compounds have found practical applications as wear resistant or protective coatings, but few have received as much attention as TiC, TiN and $Al_2O_3$.

Initially coated tools were intended for turning applications, but today tools designed for milling as well as drilling applications, are coated. Improvements of the bonding to the substrate and between different coating materials have resulted in a plurality of coating combinations with double-, triple- or multi-layer structures.

The reaction mechanisms occurring during the CVD of $Al_2O_3$ have been analysed, but little has been mentioned about the stability and microstructure of the deposited $Al_2O_3$ phases and how the formation of these phases depends on the deposition process.

$Al_2O_3$ crystallizes in several different phases of which the alpha-structure (corundum) is the thermodynamically stable phase at typical deposition temperatures. The metastable kappa-phase is the second most commonly occurring modification in CVD-$Al_2O_3$. Other infrequently occurring types are theta-, gamma- and delta-$Al_2O_3$.

In commercial tools $Al_2O_3$ is always applied on TiC-coated cemented carbide (see e.g. SE 357 984) and therefore the interface reactions on the TiC-surface are of particular importance. (With TiC-layer is also understood those layers having the formula $TiC_xN_yO_z$ in which C in TiC is completely or partly substituted by oxygen and/or nitrogen. In the system $TiC_xN_yO_z$ there is 100 % miscibility. There can be one or more layers of this kind. Similar relationships also exist within other systems e.g. Zr-C-N-O.)

The purpose of the present invention has been to obtain such an $Al_2O_3$-layer with the correct crystallography, microstructure and morphology and under nucleation conditions such that the desired $Al_2O_3$-phases will be stabilized. This object is achieved by the product as claimed in Claim 1. Preferred embodiment is defined in Claim 2.

A typical surface structure of a CVD-$Al_2O_3$ coating contains coarse-grained islands of alpha-$Al_2O_3$, the first $Al_2O_3$ phase to nucleate, surrounded by much more fine-grained kappa-$Al_2O_3$-areas. When greater amounts of such alpha-$Al_2O_3$ exist the individual islands join together. The ratio coarse-grained/fine-grained areas can vary over broad intervals.

Also the alpha/kappa ratio measured by X-ray diffraction will vary over a wide range. A higher ratio is obtained at long coating times and after further heat treatment. After about 3 hours' heat treatment at 1000°C essentially all the thermodynamically metastable kappa-$Al_2O_3$ is transformed to stable alpha-$Al_2O_3$. It is important to note that the transformation kappa $\rightarrow$ alpha takes place without any great changes in surface morphology. The alpha-$Al_2O_3$ formed from kappa is fine-grained.

The kinetics behind the phase transformation metastable kappa-$Al_2O_3$ to stable alpha-$Al_2O_3$ is not clear. It should be noted, however, that only small re-arrangements of the close-packed oxygen layers, that are common to both structures, are needed to convert kappa- to alpha-$Al_2O_3$.

In the Swedish patent No. 406090 a method of making kappa-$Al_2O_3$ has been proposed being based essentially on the fact that an addition of $TiCl_4$ to the gas mixture results in kappa-$Al_2O_3$ formation. Any kappa-phase, formed under these conditions, having an epitaxial relationship with the layer below a thick $Al_2O_3$-layer has not been formed, however. ( A thick $Al_2O_3$-layer is more than 2 µm $Al_2O_3$ ).

The microstructure of an alpha-$Al_2O_3$ coating initially nucleated as alpha-$Al_2O_3$ is characterized by a grain size of about 0.5-5 µm, preferably 0.5-2 µm, and the presence of pores. Contrary to this a kappa-$Al_2O_3$ coating is essentially pore-free and has a much smaller grain size of 0.05-1 µm, usually 0.2-0.5 µm.

The coating of bodies having an underlying coating as defined in the introductory portion of Claim 1 and an alumina coating thereon produced by a CVD process using hydrogen, carbon dioxide and comprising water in an amount of about 20 ppm is known from EP-A-0 032 387.

JP-A-54-79180 relates to the production of coated cemented carbide articles, in particular cutting tools with a TiC interlayer and an alumina top layer deposited by CVD at 600 - 1050 ° C in a stream of a mixed gas composed of $CO_2$ and/or CO, Al $Cl_3$ and $H_2$.

It is disclosed that the degree of oxidation of the interlayer largely depends on the moisture contents of the feed gas components, and that each feed gas should have a moisture content below -50° C in order to avoid deterioration of the strength or the toughness of the tool.

It has now been found that poor adhesion between the $Al_2O_3$-layer and the underlying TiC-layer is obtained if the $Al_2O_3$ in direct contact with the TiC-layer has the alpha-$Al_2O_3$ crystal structure at the time when it is nucleated. In such a case considerable porosity exists between the two layers. If kappa- or theta-$Al_2O_3$ on the other hand is in a direct contact with the TiC-layer the transition is pore-free and good adhesion is obtained. In said latter case a direct lattice relationship exists between the orientations of the $Al_2O_3$- and the TiC-layers, i.e. the $Al_2O_3$-layer grows epitaxially. The following relationships exist between TiC / kappa $Al_2O_3$:

$(1\bar{1}1)$ TiC // (0001) kappa-$Al_2O_3$

[110] TiC // $[10\bar{1}0]$ kappa-$Al_2O_3$

Both these can be interpreted as indicating that close-packed atom planes in the $Al_2O_3$- and TiC- phases are in contact and thus the adhesion across the interface between $Al_2O_3$ and TiC will be maximized. Similar epitaxial relationships should also exist between $Al_2O_3$ and metal systems related with TiC e.g. ZrC and for other carbides, carbonitrides, oxynitrides, oxycarbides, oxycarbonitrides and nitrides of metals in the groups IVB, VB and VIB of the Periodic Table and for B, Al and Si and should maximize adhesion between the phases on either side of the interface.

The process conditions governing the first nucleation event are thus of great importance. The oxidation state of the TiC-surface is decisive for the kind of nuclei which are to be formed. If the TiC-surface is (intentionally) oxidized only alpha-$Al_2O_3$ is formed. Simple calculations show that the presence of water in H2 carrier gas has a dramatic effect on the oxidation state. Already at 5 ppm water in $H_2$ at 1000 ° C and 50 mbar the TiC surface oxidizes to $Ti_2O_3$. At higher water contents (20-30 ppm ) $Ti_3O_5$ is formed. It should be observed that the formation of titanium oxide ($Ti_2O_3$, $Ti_3O_5$) involves a volume increase of 25-30 %. Also other oxygen containing compounds than water in the feed-gas can cause oxidation.

The water gas concentration in the reactor during $Al_2O_3$ coating at typical conditions for good adhesion is very small and all water is used during the hydrolysis reaction with $AlCl_3$. For a typical reactor the water content is 0.01-0.1 ppm. The water concentration varies, however, greatly during the nucleation event and can locally reach 1000-2000ppm. It is thus possible to oxidize the TiC surface during the $Al_2O_3$ nucleation stage.

Another contribution to the oxidation of the TiC-surface comes from the heterogenous decomposition of CO2, in which surface adsorbed mono-atomic oxygen can oxidize the TiC-surface.

It is surprising that such low-oxidizing conditions would be necessary to obtain a well-adherent oxide coating ($Al_2O_3$). Prior art even recommends the use of oxidized surfaces to form well-adherent dense $Al_2O_3$-coatings. (see e. g. U.S. Pats. No. 3,736,107, 3,837,896 , 4,018,631 or 4,608,098).

It has thus been found that no well-defined lattice-orientation relationship exists between TiC and alpha-$Al_2O_3$, which has been nucleated on TiC from gas phase. Instead the TiC-$Al_2O_3$ interface contains a great amount of porosity. It is therefore very probable that the nucleation of alpha-$Al_2O_3$ does not take place on TiC but on a thin oxide film of e.g. $Ti_2O_3$, $Ti_3O_5$ or $TiO_2$ what thus makes the formation of an epitaxial relationship with the underlaying TiC-surface impossible. However, because there is no trace of any intermediate layer of $Ti_2O_3$, $Ti_3O_5$ or $TiO_2$ in the final product it must be assumed that a transformation to TiO, TiCO or TiC has happened during the relatively extended coating period. The volume contraction (25-30%) which accompanies the phase transformation $Ti_3O_5$ or $Ti_2O_3$ to TiO would explain the observed interfacial porosity.

Contrary to this, kappa-$Al_2O_3$ or theta-$Al_2O_3$ is nucleated directly on non-oxidized or relatively weakly oxidized (up to highest $Ti_2O_3$) TiC-surfaces, which results in an epitaxial relationship between the TiC- and the $Al_2O_3$-layers and, as then, no reduction of $Ti_2O_3$ etc to TiO occurs, thus in the absence of porosity.

The alpha-$Al_2O_3$ is, as mentioned, the stable structure and has a higher density than kappa-$Al_2O_3$. If, during the nucleation event kappa-$Al_2O_3$ is formed then the resulting layer will have a more fine-grained and uniform structure than, in particular, a mixture of kappa- and alpha-$Al_2O_3$. If only or almost only alpha-$Al_2O_3$ is obtained it takes place in connection with the reduction of higher titanium oxides (e.g. $TiO_2$, $Ti_3O_5$) and porosity will be formed.

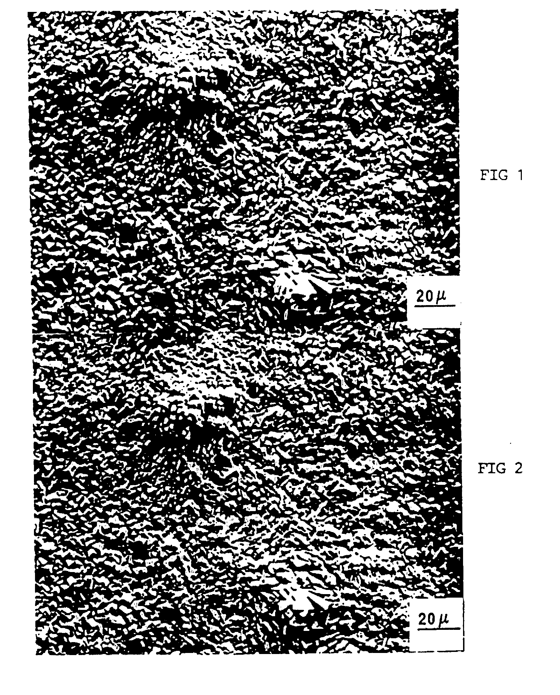

Fig. 1 shows a "prior art" $Al_2O_3$-surface consisting of initially nucleated alpha- (coarse-grained) and kappa- (fine-grained) structure.

Fig. 2 shows the same microstructural feature, but after 4 hours' heat treatment, by which a microstructure of alpha-$Al_2O_3$ of fine-grained type has been obtained (according to the invention) mixed with initially formed alpha-$Al_2O_3$ ("prior art" structure).

According to the invention there is thus now available a body such as e.g. a cutting insert for chipforming machining coated with at least one layer of $Al_2O_3$ + TiC in which the $Al_2O_3$-layer is in epitaxial contact with adjacent TiC-layer and consists of kappa- or theta-$Al_2O_3$. In general the $Al_2O_3$-layer consists of at least 90 %, preferably at least 98 % alpha-$Al_2O_3$ which has been initially nucleated as kappa- or theta-$Al_2O_3$ and which has been obtained by a subsequent heat treatment. By this measure a dense and wear resistant alpha-$Al_2O_3$ is obtained which is fine-grained and has a good bond to the underlying TiC-, TiN- or TiO-layer. The fine grain size and the good bond are caused by the exellent nucleation properties of the initially nucleated kappa-$Al_2O_3$-layer. In said respect the invention can be described as alpha-$Al_2O_3$ with kappa-$Al_2O_3$-morphology. That is, the occurrence of alpha-$Al_2O_3$ can only be verified by X-ray diffraction or similar methods.

The invention also relates to a method for obtaining $Al_2O_3$-layers with good adherence to the substrate (including the TiC, TiN etc interlayer). By said method the coating shall be performed so that oxidization of the surface of the TiC-layer is avoided at the transition to the $Al_2O_3$-coating process by keeping the water vapor concentration at the nucleation below 0.5 ppm. In this context it should be noted that the interlayer must have a thickness and such properties that metals (e.g. Co) catalyzing the $CO_2$ decomposition to oxygen and CO cannot penetrate the interlayer and cause excessive oxidation of the surface on which $Al_2O_3$ is to be nucleated. The coated body can then alternatively be heat treated in 0.3-10, preferably 1-4 hours, at temperature of 900-1000 ° C preferably in a protective gas atmosphere.

With double layer is also meant known layers of current multitype inner as well as outer layers. Also when e. g. TiC or TiN is deposited on $Al_2O_3$ the invention can be applied.

Example 1

Cutting inserts were coated under the same conditions as in Example 1 in SE 357 984 by which a 3 μm thick layer was obtained by suitably sparse packing . The water concentration was kept to such a low level before and during the $Al_2O_3$- nucleation that mainly kappa-$Al_2O_3$ was nucleated in contact with TiC, cutting insert A.

The cutting inserts were then tested with respect to edge line flaking with the result given below:
(The flaking test was performed as a facing operation of a low carbon steel test piece with intermittent cuts obtained by preformed slits cut into the test piece. Since low carbon steels vary in composition and other properties the configuration of the slits and cutting data must be adjusted by performing preliminary tests enabling final best conditions to be obtained. The result of the cutting test is expressed as the ratio of flaking length of the edge line and the total edge line in the cutting operation.)

| Test | % alpha-$Al_2O_3$ | flaking |
|---|---|---|
| A | 15 | 70 (acc. to the inv.) |
| B | 90 | 90 (known techn.) |

Testing of the wear resistance showed that the variant B, in addition, had inferior face wear resistance and shorter life.

Example 2

Cutting inserts coated under the same conditions as in Example 1 and in which the coating thus consisted essentially of about 3 μm kappa-$Al_2O_3$ were heat treated at 1020 ° C in a hydrogen gas atmosphere and the kappa-phase was succesively transformed to alpha-phase.

The inserts were then tested with respect to edge line flaking with results below:

| Test | Heat treatment time, h | % alpha-$Al_2O_3$ | flaking |
|---|---|---|---|
| C | 8 | 100 | 65 |
| D | 2 | 35 | 50 |

Testing of the wear resistance showed that the variant D had inferior face wear resistance and the shortest life of the inserts C and D.

Example 3

Cutting inserts were coated in accordance with Example 1 in SE 357 984 at which 1 μm $Al_2O_3$-layer was obtained by a dense packing of inserts and supporting details. The coated inserts had a high carbon content so that about 6 μm thick TiC-layer was formed. Inserts were taken out from different parts of the coating charge. One group of inserts had kappa-$Al_2O_3$ in contact with the TiC-layer. These inserts showed in an intermittent turning test no tendency for the $Al_2O_3$-layers to "flake" from the TiC-layer. Another group of inserts with almost only alpha-$Al_2O_3$ in contact with TiC flaked to about 45% of the surface exposed to the chip.

**Claims**

1.    Body such as a cutting insert coated with at least one layer consisting of an $Al_2O_3$-coating and an underlying coating consisting of a carbide, carbonitride, oxynitride, oxycarbide, oxycarbonitride or nitride of one metal selected from the groups IV B, V B and VI B of the Periodic Table or from B, Al and Si, in which said $Al_2O_3$-coating consists of kappa-$Al_2O_3$, the body being brought in contact at high temperature with a hydrogen carrier gas containing $CO_2$

and one or more halides of aluminium
**characterized** in, that the $Al_2O_3$-coating shows an epitaxial relationship with the underlying coating and, in case of the kappa-$Al_2O_3$ structure has a grain size of 0.05-1 µm, the water vapour content of the hydrogen gas during the nucleation event of $Al_2O_3$ being kept at a low level, below 0.5 ppm.

2. Body according to claim 1, **characterized** in that the $Al_2O_3$-coating in contact with an underlying TiC-coating consists of epitaxial kappa-$Al_2O_3$ and that the following lattice orientation relationship exists between said layers:
$(1\bar{1}1)$ TiC // (0001) kappa-$Al_2O_3$
[110] TiC // $[10\bar{1}0]$ kappa-$Al_2O_3$

**Patentansprüche**

1. Körper, wie Schneideinsatz, der mit wenigstens einer Schicht überzogen ist, die aus einem $Al_2O_3$-Überzug und einem darunterliegenden Überzug aus einem Carbid, Carbonitrid, Oxinitrid, Oxicarbid, Oxicarbonitrid oder Nitrid eines Metalles aus den Gruppen IVB, VB und VIB des Periodensystems oder aus B, Al und Si besteht, wobei dieser $Al_2O_3$-Überzug aus kappa-$Al_2O_3$ besteht, wobei der Körper bei hoher Temperatur in Berührung mit einem Wasserstoffträgergas gebracht wird, das $CO_2$ und eines oder mehrere Aluminiumhalogenide enthält, **dadurch gekennzeichnet**, daß der $Al_2O_3$-Überzug eine epitaxische Beziehung zu dem darunterliegenden Überzug zeigt und im Falle der kappa-$Al_2O_3$-Struktur eine Komgröße von 0,05 bis 1 µm hat, wobei der Wasserdampfgehalt des Wasserstoffgases während der Keimbildung von $Al_2O_3$ auf einem niedrigen Wert unter 0,5 ppm gehalten wird.

2. Körper nach Anspruch 1, dadurch gekennzeichnet, daß der $Al_2O_3$-Überzug in Berührung mit einem darunterliegenden TC-Überzug aus epitaxischem kappa-$Al_2O_3$ besteht und daß die folgende Gitterausrichtungsbeziehung zwischen diesen Schichten besteht:
(111) TiC // (0001) kappa-$Al_2O_3$
[110] TiC // [1010] kappa-$Al_2O_3$.

**Revendications**

1. Corps, tel qu'une plaquette de coupe, revêtu d'au moins une couche composée d'un revêtement de $Al_2O_3$ et d'un revêtement sous-jacent composé d'un carbure, carbonitrure, oxynitrure, oxycarbure, oxycarbonitrure ou nitrure d'un métal choisi dans des groupes IVB, VB et VIB de la classification périodique, ou entre B, Al et Si, dans lequel le revêtement de $Al_2O_3$ est composé de kappa-$Al_2O_3$ le corps étant mis en contact à haute température avec un gaz véhicule composé d'hydrogène contenant du $Co_2$ et ou un plusieurs halogénures d'aluminium, caractérisé en ce que le revêtement de $Al_2O_3$ présente une relation épitaxiale avec le revêtement sous-jacent et en ce que, dans le cas de la kappa-$Al_2O_3$, la structure a une grosseur de grain de 0,05 à 1 µm, la teneur en vapeur d'eau de l'hydrogène gazeux pendant l'événement de nucléation de $Al_2O_3$ étant maintenue à un bas niveau, inférieur à 0,5 ppm.

2. Corps selon la revendication 1, caractérisé en ce que le revêtement de $Al_2O_3$ en contact avec un revêtement de TiC sous-jacent est composé de kappa-$Al_2O_3$ épitaxiale et en ce que la relation d'orientation de réseau suivante existe entre lesdites couches :
$(1\bar{1}1)$ TiC // (0001) kappa-$Al_2O_3$
[110] TiC // $[10\bar{1}0]$ kappa-$Al_2O_3$.

FIG 1

20 μ

FIG 2

20 μ